Europäisches Patentamt

European Patent Office

Office européen des brevets

(11) Veröffentlichungsnummer : **0 037 574
B1**

# EUROPÄISCHE PATENTSCHRIFT

(45) Veröffentlichungstag der Patentschrift :
07.11.84

(21) Anmeldenummer : 81102582.4

(22) Anmeldetag : 06.04.81

(51) Int. Cl.³ : **H 05 K 9/00**, G 12 B 17/00,
**H 05 K 5/06**

(54) **Anordnung für ein hochfrequenz- und wasserdichtes Gehäuse für elektrische Geräte.**

(30) Priorität : 08.04.80 DE 3013489

(43) Veröffentlichungstag der Anmeldung :
14.10.81 Patentblatt 81/41

(45) Bekanntmachung des Hinweises auf die Patenterteilung : 07.11.84 Patentblatt 84/45

(84) Benannte Vertragsstaaten :
**BE GB IT NL**

(56) Entgegenhaltungen :
**DE-A- 1 615 901**
**DE-A- 1 791 205**
**DE-A- 2 134 815**
**DE-A- 2 652 082**
**DE-A- 2 932 015**

(73) Patentinhaber : **Siemens Aktiengesellschaft
Berlin und München Wittelsbacherplatz 2
D-8000 München 2 (DE)**

(72) Erfinder : **Essler, Otto, Ing. grad.
Schlüsselbergstrasse 8
D-8000 München 80 (DE)**

**Beschreibung**

Die Erfindung betrifft eine Anordnung für ein hochfrequenz- und wasserdichtes Gehäuse für elektrische Geräte, das eine Frontplatte aufweist und allseitig geschlossen ist, wobei die Unterseite und die Oberseite des Gehäuses durch je einen Deckel abgeschlossen sind.

Gehäuse zur Aufnahme von elektrischen Geräten müssen häufig gegen Hochfrequenzeinflüsse abgeschirmt oder abgedichtet werden. Man hat dabei schon seit langem erkannt, daß die einfache Berührung zwischen den einzelnen Metallteilen eines solchen Gehäuses allein nicht ausreicht, um eine hohen Anforderungen genügende Abschirmung zu gewährleisten. Aus diesem Grund sind bereits eine Reihe von Maßnahmen zur Verbesserung der elektrischen Abdichtung oder Abschirmung bekannt geworden. Beispielsweise wurden außer den Verbindungselementen, mit denen die Einzelteile solcher Gehäuse verbunden werden, zusätzlich Kontaktelemente, beispielsweise Kontaktfedern vorgesehen, die durch den beim Zusammenbau entstehenden Druck eine verbesserte leitende Verbindung zwischen den einzelnen Teilen herstellen.

Da die Fremdschichten auf den kontaktierend zu verbindenden Metalloberflächen durch den Druck einer Kontaktfeder kaum angegriffen werden, ist es bereits bekannt, die Kontaktfedern derart zu gestalten, daß sie beidseitig mit einer großen Anzahl scharfer Schnittkanten versehen sind, die sich beim Verschrauben in die Oberfläche der Schirmungselemente eingraben. Beim Zusammenschrauben der Schirmungselemente durchstoßen die scharfen Schnittkanten die Fremdschichten, beispielsweise die Oxydschichten auf den Schirmungselementen, wodurch sich eine Verbesserung der Kontaktierung zwischen den einzelnen Teilen eines abgeschirmten Gehäuses ergibt.

Die Verwendung von Kontaktfedern oder von gezackten Scheiben zur Verbesserung der Kontaktgabe zwischen miteinander zu verbindenden Teilen stellt jedoch nicht immer die optimale Lösung dar. So kann mit einer solchen Anordnung jeweils nur eine punktförmige, unmittelbare Berührung zwischen den Metallteilen erreicht werden, da letztlich nur die scharfen Schnittkanten die Fremdschichten durchstoßen. Die Kontaktfläche ist demnach relativ klein. Wenn die Wände eines solchen abgeschirmten Gehäuses aus Aluminiumplatten oder aus Platten mit Aluminiumverbindungen aufgebaut werden, entstehen schon nach sehr kurzer Zeit auf den Platten ungewöhnlich dicke Fremdschichten von Aluminiumoxyd, die nur durch entsprechend groß dimensionierte Kontaktfedern mit scharfen Kanten oder Zacken mit Sicherheit durchstoßen werden. Schließlich ist die Verwendung von Kontaktfedern der genannten Art bei der Verschraubung großer Gehäuseteile auch deshalb nicht zweckmäßig, weil durch die dabei auftretenden Kräfte die Kontaktfedern leicht zerstört werden. Soll das Gehäuse auch noch wasserdicht sein und höheren Anforderungen hinsichtlich mechanischer Einflüsse entsprechen, so ist ein zusätzlicher erheblicher Aufwand erforderlich. Ein derartiges Gehäuse schränkt jedoch die Wartungs- und Prüffreundlichkeit des elektrischen Gerätes erheblich ein.

Aufgabe der Erfindung ist es, ein Gehäuse für elektrische Geräte aufzuzeigen, das erhöhten klimatischen, mechanischen und elektromagnetischen Anforderungen gerecht wird und eine einfache Wartung und Prüfung des elektrischen Gerätes ermöglicht.

Diese Aufgabe wird durch die Merkmale des kennzeichnenden Teils des Anspruches 1 gelöst.

Das neue Gehäuse hat den Vorteil, daß es im Aufbau besonders einfach ist und trotzdem höchsten klimatischen, mechanischen und elektromagnetischen Anforderungen entspricht. Das Gehäuse ermöglicht einen besonders einfachen Einbau der elektrischen Geräte und ist bedienungs-, wartungs- und prüffreundlich. Das Gehäuse ist schüttel- und schlagfest, wasserdicht und staubgeschützt. Das Gehäuse schützt gegen elektromagnetische Ein- und Abstrahlung. Es ermöglicht eine vorteilhafte wirtschaftliche Fertigung. Das neue Gehäuse ermöglicht eine variable Baugruppenbestückung des elektrischen Gerätes durch auswechselbare Innenwände, in denen die Leiterplattenführungen eingearbeitet sind. Weiterhin besteht die Möglichkeit der Bildung von unterschiedlichen, für sich abgeschirmten Geräteteilen innerhalb des Gehäuses durch Schirmbleche oder Abschottungen. Durch den Einsatz von Schirmblechen und Wäremableitblechen wird eine gute Wärmeableitung erreicht. Das Gehäuse eignet sich besonders vorteilhaft für den Einbau von Funk-, Meß-, Schlüssel- und Übertragungsgeräten.

Einzelheiten der Erfindung werden im folgenden anhand eines vorteilhaften Ausführungsbeispiels, das in den Figuren dargestellt ist, erläutert. Es zeigen:

Figur 1 eine perspektivische Ansicht des Gehäuses mit eingesetzten Leiterplatten sowie abgenommenem Deckel und Spannvorrichtung,

Figur 2 in perspektivischer Teilansicht einen Schnitt durch das Gehäuseoberteil bei geschlossenem Deckel,

Figuren 3, 4, 5 verschiedene Möglichkeiten der Anbringung von Abschirm- und Wärmeleitblechen innerhalb des Gehäuses.

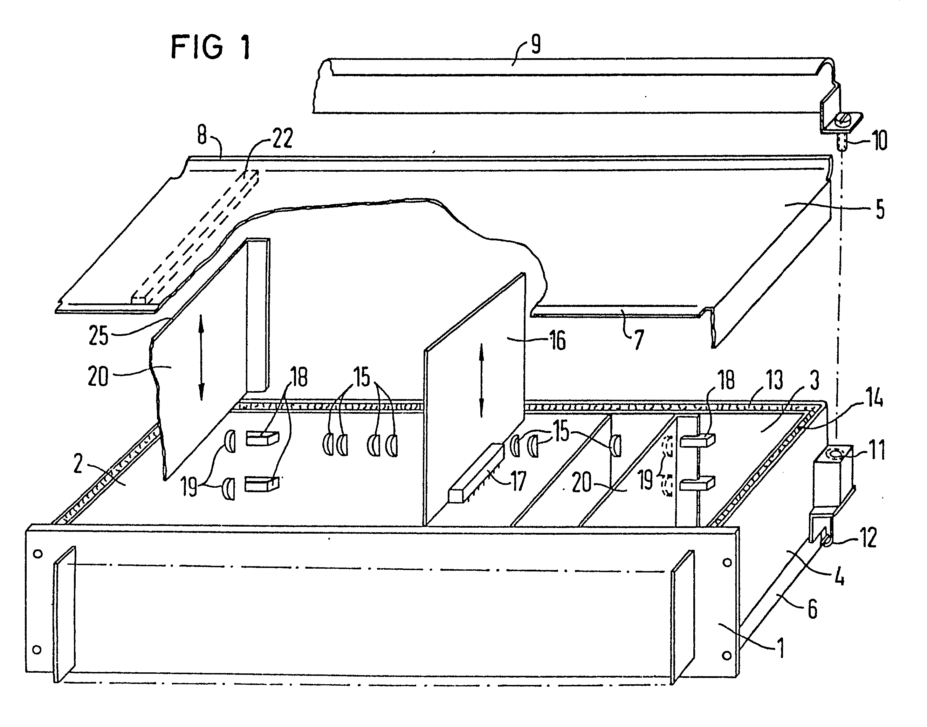

Das in der Fig. 1 dargestellte Gehäuse für ein elektrisches Gerät besteht im wesentlichen aus einer Frontplatte 1, einem doppelwandigen U-förmigen Rahmen 2, den Deckeln 5 und 6, einem oberen Spannbügel 9 für den Deckel 5 und einem unteren Spannbügel 12 für den Deckel 6. Die Frontplatte ist beispielsweise aus Aluminium-Druckguß hergestellt. Die Schenkel des U-förmigen Rahmens sind mit der Frontplatte fest verbunden, beispielsweise angeflanscht. Die offenen Flächen oben und unten werden durch den oberen Deckel 5 und den unteren Deckel 6 abgedeckt. Beim Zusammenbau entsteht ein allseitig geschlossenes Gehäuse. Der U-förmige Rahmen 2 besteht aus einer Außenwand 4 und einer variablen Innenwand 3, die miteinander fest verbunden sind, beispielsweise verschraubt. In der auswechselbaren Innenwand 3 des U-förmigen Rahmen 2 sind Führungen 15 für die Baugruppen 16 des elektrischen Gerätes angebracht. Die Frontplatte 1 ist ebenfalls für verschiedene Anwendungsfälle auswechselbar und weist entsprechende Führungen für die Leiterplatten auf. Als Grund- oder Geräteverdrahtung liegt eine Leiterplatte im unteren Bereich des U-förmigen Rahmens parallel zum unteren Deckel, wodurch die untere offene Fläche im wesentlichen abgedeckt wird. Die Baugruppen 16 werden über Steckverbinder 17 mit dieser Leiterplatte verbunden. Durch Abnehmen des unteren Deckels 6 ist die gesamte Verdrahtung des Gerätes für Meß- und Servicezwecke zugänglich. An der variablen Innenwand 3 sind federnd Befestigungselemente 18 und Führungselemente 19 für die Anbringung von Schirm- oder Wärmeleitblechen 20 vorgesehen, die aus der Innenwand herausgeprägt sind. Dadurch ist es möglich, Geräteteile innerhalb des Gehäuses in eigenen Schotten ein- und abstrahlungssicher anzuordnen oder die durch die Verlustleistung auftretende Wärme sicher über das gesamte Gehäuse abzuführen.

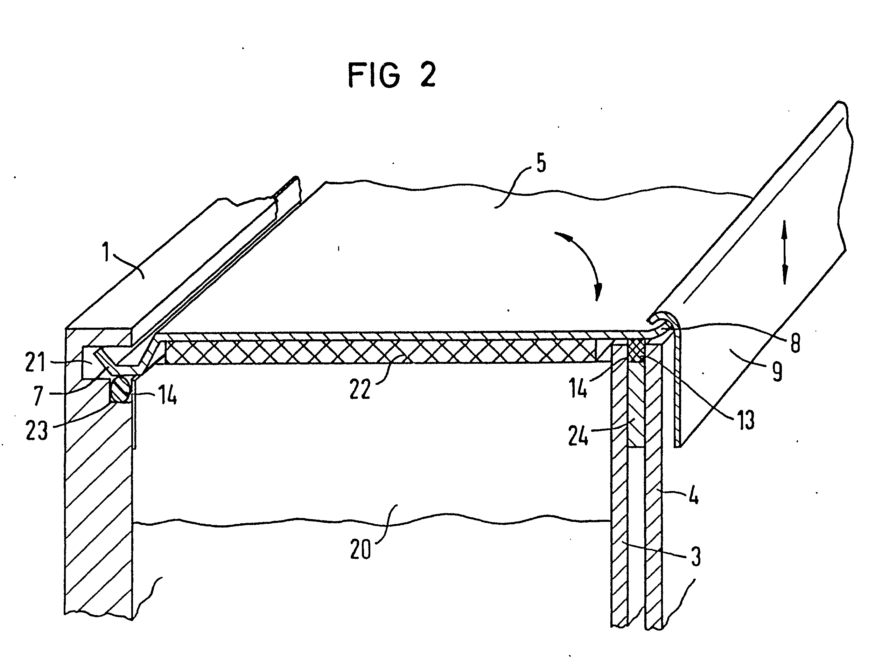

Der Gehäuseaufbau wird unten und oben durch die Deckel 6 und 5 abgeschlossen. Jeder Deckel weist eine vordere Spannkante 7 und eine hintere Spannkante 8 auf. In der Fig. 1 ist der untere Deckel 6 geschlossen und der obere Deckel 5 und der obere Spannbügel 9 abgehoben dargestellt. Die Frontplatte 1 weist am unteren und oberen Ende in der Höhe der offenen Flächen eine horizontal verlaufende Nut 21 auf (Vgl. Fig. 2), in die jeweils die vordere Spannkante 7 des Deckels eingelegt wird. Über die hintere Spannkante 8 des Deckels 5 wird der Spannbügel 9 geschoben. Mit Hilfe der seitlich am Spannbügel angebrachten Befestigungsschrauben 10, die mit wenigen Umdrehungen in einem an der Außenwand 4 angebrachten Befestigungsgewinde 11 eingeschraubt werden, wird der Deckel 5 auf die an den offenen Flächen umlaufenden Dichtungselemente 14 gedrückt. Zwischen der Außenwand 4 und der Innenwand 3 des U-förmigen Rahmens 2 ist eine umlaufende Nut 13 ausgebildet, in der die Hochfrequenz- und Feuchtigkeitsdichtungselemente 14 eingedrückt sind. Für die Schirmbleche 20 sind die Dichtungselemente 22 an der Innenseite des oberen und unteren Deckels angebracht. Als Hochfrequenz- und Feuchtigkeitsdichtung wird ein Drahtgeflecht verwendet, das federnd auf Gummi- oder Kunststoffelementen aufgebracht ist. Vorteilhaft eignet sich ein aus Monel ® bestehendes Geflecht. Die Spannbügel 9 und 12 können im entspannten Zustand, der durch wenige Umdrehungen der seitlich angebrachten Schrauben 10 erreicht wird, einfach und leicht über die hintere Spannkante 8 des Deckels 5 geschoben werden. Der Deckel wird hochgeklappt und die vordere Spannkante aus der Führungsnut 21 in der Frontplatte 1 herausgezogen. Damit kann das Gehäuse wirkungsvoll und schnell verschlossen und geöffnet werden. Zusätzliche Schraubverbindungen oder Schraubelemente sind nicht erforderlich. In der Fig. 1 ist der untere Spannbügel 12 über die hintere Spannkante des unteren Deckels 6 geschoben und durch Einschrauben der seitlich angebrachten Befestigungsschrauben in das Befestigungsgewinde gespannt. Der Deckel 6 ist in der unteren offenen Fläche gegen die in der umlaufenden Nut zwischen Außenwand und Innenwand angebrachten Dichtungselemente gedrückt. Die Hochfrequenz- und Feuchtigkeitsdichtungselemente werden vorteilhaft in der Nut und an der Innenseite des Deckels angeklebt.

Die Fig. 2 zeigt im Schnitt den oberen Deckel 5 im geschlossenen Zustand des Gehäuses. Die Frontplatte 1 weist eine quer verlaufende Führungsnut 21 für die vordere Spannkante 7 des Deckels 5 auf. In dieser Nut ist eine weitere in derselben Richtung verlaufende Nut 23 herausgearbeitet, in der ebenfalls Hochfrequenz- und Feuchtigkeitsdichtungselemente 14 befestigt sind. Der U-förmige Rahmen besteht aus der Außenwand 4 und der variablen Innenwand 3. An der variablen Innenwand ist ein umlaufender Metallstreifen 24 punktförmig angeschweißt. In diesem Metallstreifen sind Gewinde angebracht, so daß mit Schrauben — sind in der Fig. 2 nicht dargestellt — eine Befestigung der Außenwand 4 an der Innenwand 3 erfolgt. In der durch die Metallstreifen gebildeten umlaufenden Nut 13 sind die Hochfrequenz- und Feuchtigkeitsdichtungselemente 14 angeordnet.

Beim Schließen des Deckels 5 wird die gekröpfte vordere Spannkante 7 des Deckels 5 in die Führungsnut 21 eingesetzt, wobei der Deckel in der eingezeichneten Pfeilrichtung nach oben geschwenkt ist. Nachdem die Spannkante 7 in der Führungsnut 21 eingesetzt ist, wird von Hand der Deckel in Pfeilrichtung nach unten gegen die Dichtungselemente 14 gedrückt. Dadurch wird bereits der gekröpfte Teil der vorderen Spannkante 7 in der Nut 21 gegen die Dichtungselemente 14 gedrückt. Der Spannbügel 9 wird über die hintere Spannkante 8 des Deckels 5 geschoben. Mit den in Fig. 2 nicht dargestellten Befestigungsschrauben 10 (Fig. 1) wird der Spannbügel 9 gespannt und dadurch der Deckel gegen die umlaufenden Dichtungselemente 14 gedrückt. An der Deckelinnenseite sind Dichtungselemente 22 für die Zwischenwand 20 befestigt, die im gespannten Zustand gegen die Oberkante 25 der Zwischenwand gedrückt sind.

Beim Öffnen eines Deckels werden die seitlichen Schrauben mit wenigen Umdrehungen geöffnet und der Spannbügel manuell über die hintere Spannkante des Deckels zurückgezogen. Danach wird durch die Federwirkung des Deckelverschlusses der Deckel sich bereits automatisch in Pfeilrichtung nach oben bewegen. Der Deckel wird von Hand weiter in der Pfeilrichtung nach oben geschwenkt, und sobald die untere Spannkante 7 in der Führungsnut 21 frei ist, kann der Deckel abgehoben werden. Der in Fig. 2 dargestellte obere Deckel 5 mit seinen Verschluß- und Dichtungselementen ist spiegelbildlich auch an der unteren Seite des Gehäuses angebracht. Weitere Elemente zum raschen und sicheren Schließen und Öffnen des Gehäuses sind nicht erforderlich.

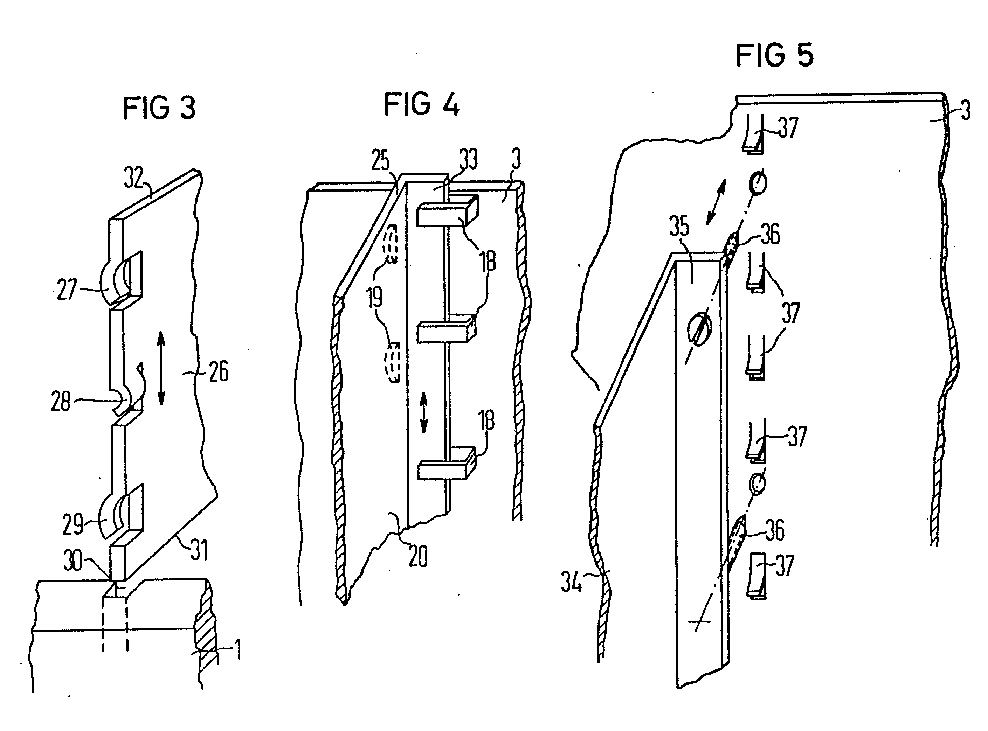

Die Figuren 3, 4 und 5 zeigen verschiedene Ausführungsbeispiele für die Kontaktierung von Schirm- und Wärmeableitblechen. Aus elektromagnetischen oder wärmetechnischen Gründen ist es oft erforderlich, Schirm- oder Wärmeableitbleche als Zwischenwände, auch Schotten genannt, im Gehäuse vorzusehen. Damit eine hohen Anforderungen entsprechende Sicherheit gegen elektromagnetische Ein- und Abstrahlung oder eine gute Wärmeleitfähigkeit erreicht wird, müssen daher die Bleche mit der Innenwand des U-förmigen Rahmens des Gehäuses und der Frontplatte elektrisch und gut wärmeleitend verbunden sein.

Fig. 3 zeigt eine Zwischenwand 26 mit federnden Kontaktstellen, die aus der Zwischenwand herausgearbeitet sind. Die Zwischenwand weist geprägte, federnde Lappen 27, 28 und 29 auf. Die Lappen sind gekrümmt, so daß sie bogenförmig aus der Oberfläche der Zwischenwand 26 herausragen. Die Lappen sind derart ausgeprägt, daß abwechselnd jeweils ein Lappen 27, 29 nach der einen und ein Lappen 28 nach der anderen Seite herausragt. Die Lappen sind auf beiden Seiten der Zwischenwand herausgeprägt und gleichmäßig über die Höhe der Zwischenwand verteilt. In der Frontplatte 1 und in der gegenüberliegenden Innenwand des U-förmigen Rahmens ist jeweils eine in vertikaler Richtung verlaufende Nut 30 vorgesehen, in die die Zwischenwand in Pfeilrichtung nach unten eingeschoben wird. In der Pfeilrichtung nach oben wird die Zwischenwand aus der Nut 30 herausgezogen. Die federnden Lappen 27, 28 und 29 sorgen für eine ausreichende Kontaktierung der Zwischenwand mit der Frontplatte bzw. der Innenwand des U-förmigen Rahmens. Die Unterseite 31 und Oberseite 32 der Zwischenwand 26 sind im geschlossenen Zustand des Gehäuses über Hochfrequenz- und Feuchtigkeitsdichtungselemente mit der Innenseite des oberen und unteren Deckels verbunden.

Fig. 4 zeigt einen Ausschnitt aus einer U-förmig ausgebildeten Zwischenwand 20 mit zwei Schenkeln 33. Aus den gegenüberliegenden Innenwänden des Gehäuses sind federnde L-förmige Lappen 18 herausgeprägt, die in den Innenraum des Gehäuses ragen. Die Zwischenwand 20 wird mit den Schenkeln 33 in Pfeilrichtung nach unten in den Zwischenraum zwischen den L-förmigen Lappen 18 und der Innenwand 3 des Gehäuses eingeklemmt, wobei die gleichmäßig verteilten Lappen federnd auf der Innenfläche des Schenkels 33 aufliegen. Dadurch wird eine federnde Klemmverbindung mit der Innenwand 3 des Gehäuses erreicht. Zur Vermeidung des Herausfallens der Zwischenwand aus den federnden Lappen 18 sind in einem der Dicke der Zwischenwand 20 angepaßten Abstand vor dem offenen Ende der L-förmigen Lappen 18 Führungen 19 angebracht. Diese Führungen 19 sind ebenfalls aus den gegenüberliegenden Innenwänden des Gehäuses herausgeprägt.

Die Fig. 5 zeigt ein weiteres Ausführungsbeispiel für die Kontaktierung der Zwischenwand mit der Innenwand des Gehäuses. Die Zwischenwand 34 ist ebenfalls U-förmig ausgebildet, wobei die Verbindung der Schenkel 35 mit den einander gegenüberliegenden Innenwänden des Gehäuses mittels Schraubverbindung erfolgt. Zur Erzielung einer guten Kontaktierung sind aus den gegenüberliegenden Innenwänden federnde Lappen 37 herausgeprägt, die mit ihren Enden in den Innenraum des Gehäuses ragen. Beim Anschrauben der Schenkel 35 der U-förmigen Zwischenwand 34 werden die Enden der Lappen in die Außenflächen der Schenkel 35 eingedrückt, so daß sich eine gute Kontaktierung zwischen Gehäuse und Zwischenwand ergibt. Die Ober- und Unterseite der Zwischenwand 34 werden über Hochfrequenz- und Feuchtigkeitsdichtungselemente, die an der Innenseite der Deckel angebracht sind, abgeschlossen.

Die in den Figuren 3 bis 5 aufgezeigten Ausführungsbeispiele für die Anordnung und Kontaktierung der Zwischenwände im Innenraum des Gehäuses ermöglichlichen eine einfache Montage und sind wirtschaftlich zu fertigen.

**Ansprüche**

1. Anordnung für ein hochfrequenz- und wasserdichtes Gehäuse für elektrische Geräte, das eine Frontplatte aufweist und allseitig geschlossen ist, wobei die Unterseite und die Oberseite des Gehäuse durch je einen Deckel abgeschlossen sind, dadurch gekennzeichnet, daß ein doppelwandiger U-förmiger Rahmen (2) vorgesehen ist, dessen Schenkel an ihren freien Enden an der Frontplatte (1) befestigt sind, daß die Frontplatte (1) in Höhe der oberen und unteren offenen Flächen des U-förmigen Rahmens (2) je eine Führungsnut (21) aufweist, in die eine als Spannkante ausgebildete Seite (7) des jeweils eine der offenen Flächen abdeckenden Deckels (5, 6) einschiebbar ist, daß die der jeweiligen Führungsnut (21) gegenüberliegende andere Seite jedes Deckels (5, 6) ebenfalls als Spannkante (8) ausgebildet ist, über die ein Spannbügel (9) schiebbar ist, der im gespannten Zustand den Deckel (5, 6) auf an den offenen Flächen umlaufende Dichtungselemente (14) drückt.

2. Anordnung nach Anspruch 1, dadurch gekennzeichnet, daß der Deckel (5) in der Führungsnut (21) schwenkbar angeordnet ist und daß die in der Nut (21) eingelegte Seite (7) des Deckels im geschlossenen Zustand des Gehäuses auf die in der Nut angebrachten Dichtungselemente (14) gedrückt ist (Fig. 2).

3. Anordnung nach Anspruch 2, dadurch gekennzeichnet, daß in der Führungsnut (21) der Frontplatte (1) eine weitere Nut (23) angebracht ist, in der die Dichtungselemente (14) befestigt sind (Fig. 2).

4. Anordnung nach Anspruch 1, dadurch gekennzeichnet, daß der U-förmige Rahmen (2) aus einer Außenwand (4) und einer auswechselbaren Innenwand (3) besteht und daß die auswechselbare Innenwand (3) mit der Außenwand (4) des U-förmigen Rahmens (2) derart verbunden ist, daß sich in der Höhe der beiden offenen Flächen jeweils eine umlaufende Nut (13) ergibt, in der die Dichtungselemente (14) befestigt sind.

5. Anordnung nach Anspruch 4, dadurch gekennzeichnet, daß zwischen der Innenwand (3) und der Außenwand (4) in einem der Höhe der Nut entsprechenden Abstand unterhalb der Außenkante der Innenwand ein Metallstreifen (24) fest angebracht ist und daß die Außenwand (4) an dem Metallstreifen lösbar befestigt ist.

6. Anordnung nach Anspruch 2, dadurch gekennzeichnet, daß am Spannbügel (9) seitlich Schrauben (10) angeordnet sind, die in ein an der Außenwand (4) angebrachtes Befestigungsgewinde (11) einschraubbar sind.

7. Anordnung nach einem der Ansprüche 1 bis 6, dadurch gekennzeichnet, daß an der Innenseite des Deckels (5) Dichtungselemente (22) befestigt sind, die im geschlossenen Zustand des Deckels gegen die Oberkante (25) bzw. Unterkante einer Zwischenwand (20) gedrückt sind.

8. Anordnung nach einem der Ansprüche 1 bis 7, dadurch gekennzeichnet, daß die Dichtungselemente (14, 22) als Hochfrequenz- und Feuchtigkeitsdichtungen ausgebildet sind.

9. Anordnung nach Anspruch 7, dadurch gekennzeichnet, daß aus der Zwischenwand (26) an gegenüberliegenden Seiten aus der Oberfläche herausragende Lappen (27, 28, 29) geprägt sind und daß die mit den Lappen versehenen Seiten der Zwischenwand (26) in an der Frontplatte (1) und der gegenüberliegenden Innenwand (3) angebrachten Nuten (30) einklemmbar sind.

10. Anordnung nach einem der Ansprüche 7 bis 9, dadurch gekennzeichnet, daß die Zwischenwand (20) U-förmig ausgebildet ist und mit den Schenkeln (33) in an der Frontplatte (1) und der gegenüberliegenden Innenwand (3) in regelmäßigem Abstand geprägten L-förmigen Lappen (18) einklemmbar ist und daß in einem der Dicke der Zwischenwand (20) entsprechenden Abstand vor den L-förmigen Lappen aus der Innenwand Führungen (19) geprägt sind.

## Claims

1. An arrangement for a high frequency- and watertight housing for electrical apparatus, which has a front plate and is closed on all sides, the under side and the upper side of the housing being closed by a respective cover, characterised in that a doublewalled U-shaped frame (2) is provided, the limbs of which are secured to the front plate (1) at their free ends ; that at the height of the upper and lower open faces of the U-shaped frame (2), the front plate (1) has a respective guide groove (21), into which one side (7), formed as a gripping edge, of the cover (5, 6) which covers a respective one of the open faces, can be inserted ; that the other side of each cover (5, 6), which lies opposite the respective guide groove (21), is also formed as a gripping edge (8), over which a clamping clip (9) can be slid which, in the clamped state, presses the cover (5, 6) against sealing elements (14) which run round the open faces.

2. An arrangement according to Claim 1, characterised in that the cover (5) is pivotably arranged in the guide groove (21) and that the side (7) of the cover which is inserted into the groove (21) is pressed in the closed state against the sealing elements (14), which are disposed in the groove, (Fig. 2).

3. An arrangement according to Claim 2, characterised in that a further groove (23), in which the sealing elements (14) are fixed, is formed in the guide groove (21) at the front plate (1), (Fig. 2).

4. An arrangement according to Claim 1, characterised in that the U-shaped frame (2) consists of an outer wall (4) and an exchangeable inner wall (3) ; and that the exchangeable inner wall (3) is connected to the outer wall (4) of the U-shaped frame (2) in such a way that, at the height of the two open faces, a peripheral groove (13) in which the sealing elements (14) are fixed, results in each case.

5. An arrangement according to Claim 4, characterised in that between the inner wall (3) and the outer wall (4), a metal strip (24) is firmly fixed below the outer edge of the inner wall at a distance which corresponds to the height of the groove ; and that the outer wall (4) is detachably secured to the metal strip.

6. An arrangement according to Claim 2, characterised in that screws (10), which can be screwed into a fastening thread (11) disposed at the outer wall (4), are laterally arranged on the clamping clip (9).

7. An arrangement according to one of Claims 1 to 6, characterised in that to the inner side of the cover (5), sealing elements (22) are fastened, which, in the closed state of the cover, are pressed against the upper edge (25), or lower edge, of a partition (20).

8. An arrangement according to one of Claims 1 to 7, characterised in that the sealing elements (14, 22) are in the form of high frequency and moisture seals.

9. An arrangement according to Claim 7, characterised in that tabs (27, 28, 29) are formed from the partition (26) on opposite sides thereof ; and that the sides of the partition (26), which are provided with the tabs, can be clamped into grooves (30) on the front plate (1) and the oppositely arranged inner wall (3).

10. An arrangement according to one of Claims 7 to 9, characterised in that the partition (20) is U-shaped and the limbs of which can be clamped in L-shaped tabs (18), which are stamped at regular intervals in the front plate (1) and the opposite inner wall (3) ; and that guides (19) are formed from the inner wall at a spacing which corresponds to the thickness of the partition (20), in front of the L-shaped tabs.

## Revendications

1. Agencement pour un boîtier prévu pour des appareils électriques et qui est étanche aux hautes fréquences et à l'eau, comportant une plaque avant et étant fermée de tous côtés, la face et la face supérieure du boîtier étant fermées par des couvercles respectifs, caractérisé par le fait qu'il est prévu un cadre (2) en forme de U à paroi double, dont les branches sont fixées au niveau de leurs extrémités libres sur la plaque avant (1), que cette plaque avant (1) comporte, au niveau des surfaces ouvertes supérieure et inférieure du cadre (2) en forme de U, une rainure de guidage (21) dans laquelle peut être inséré un côté (7), réalisé sous la forme d'un bord de serrage, du couvercle respectif (5, 6) fermant les surfaces ouvertes, que l'autre côté, situé en vis-à-vis de la rainure respective de guidage (21) de chaque couvercle (5, 6), est également réalisé sous la forme d'un bord de serrage (8), par-dessus lequel peut être inséré un étrier de serrage (9) qui, à l'état tendu, repousse le couvercle (5, 6) sur les organes d'étanchéité (14) situés sur le pourtour des surfaces ouvertes.

2. Agencement suivant la revendication 1, caractérisé par le fait que le couvercle (5) est monté de façon à pouvoir pivoter dans la rainure de guidage (21) et que le côté (7) du couvercle, qui est inséré dans la rainure (21), est repoussé sur les organes d'étanchéité (14) disposés dans la rainure lorsque le boîtier est à l'état fermé (figure 2).

3. Agencement suivant la revendication 2, caractérisé par le fait que dans la rainure de guidage (21) de la plaque avant (1) se trouve disposée une rainure supplémentaire (23) dans laquelle les organes d'étanchéité (14) sont fixés (figure 2).

4. Agencement suivant la revendication 1, caractérisé par le fait que le cadre (2) en forme de U est constitué par une paroi extérieure (4) et par une paroi intérieure interchangeable (3) et que la paroi intérieure interchangeable (3) est reliée à la paroi extérieure (4) du cadre (2) en forme de U de manière à former, au niveau des deux surfaces ouvertes, une rainure périphérique respective (13) dans laquelle les organes d'étanchéité (14) sont fixés.

5. Agencement suivant la revendication 4, caractérisé par le fait qu'une bande métallique (24) est montée fixe entre la paroi intérieure (3) et la paroi extérieure (4) à une distance, correspondant à la hauteur de la rainure, au-dessous du bord extérieur de la paroi intérieure et que la paroi extérieure (4) est fixée de façon détachable sur la bande métallique.

6. Agencement suivant la revendication 2, caractérisé par le fait que sur l'étrier de serrage (9) se trouvent disposées, latéralement, des vis (10) qui peuvent être vissées dans un filetage de fixation (11) ménagé sur la paroi extérieure (4).

7. Agencement suivant l'une des revendications 1 à 6, caractérisé par le fait que sur la face intérieure du couvercle (5) sont fixés des organes d'étanchéité (22) qui sont repoussés contre le bord supérieur (25) ou le bord inférieur d'une paroi intercalaire (20), lorsque le couvercle est à l'état fermé.

8. Agencement suivant l'une des revendications 1 à 7, caractérisé par le fait que les organes d'étanchéité (14, 22) sont réalisés sous la forme de garnitures d'étanchéité aux hautes fréquences et à l'humidité.

9. Agencement suivant la revendication 7, caractérisé par le fait que des languettes (27, 28, 29) faisant saillie à partir de la surface, sur des faces opposées, sont ménagées par estampage dans la paroi intercalaire (26) et que les faces de la paroi intercalaire (26) qui sont munies des languettes, peuvent être serrées dans des rainures (30) ménagées dans la plaque avant (1) et dans la paroi intérieure opposée (30).

10. Agencement suivant l'une des revendications 7 à 9, caractérisé par le fait que la paroi intercalaire (20) est réalisée en forme de U et peut être serrée par ses ailes (33) dans des languettes en forme de L (18) ménagées par estampage à des intervalles réguliers dans la plaque avant (1) et dans la paroi intérieure opposée (3), et que des guides (19) sont ménagés par estampage dans la paroi intérieure à une distance correspondant à l'épaisseur de la paroi intercalaire (20), en avant des languettes en forme de L.

FIG 1

0 037 574

FIG 2

FIG 3

FIG 4

FIG 5

32

27

28

26

29

31

30

1

25    33    3

19

18

18

20

3

37

35    36

34    37

37

36

37

0 037 574

3